Europäisches Patentamt

European Patent Office

Office européen des brevets

(19)

(11) **EP 1 569 031 A1**

(12) **EUROPEAN PATENT APPLICATION**

(43) Date of publication:
**31.08.2005 Bulletin 2005/35**

(51) Int Cl.[7]: **G02F 1/35**

(21) Application number: **05250612.8**

(22) Date of filing: **03.02.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **25.02.2004 US 786342**

(71) Applicant: **RAYTHEON COMPANY
Massachusetts 02451-1449 (US)**

(72) Inventors:
• **Byren, Robert W.
Manhattan Beach, CA 90266 (US)**
• **Rockwell, David A.
Culver City, CA 90232 (US)**
• **Betin, Alexander A.
Manhattan Beach, CA 90166-6014 (US)**

(74) Representative: **Jackson, Richard Eric et al
Carpmaels & Ransford,
43-45 Bloomsbury Square
London WC1A 2RA (GB)**

(54) **Stimulated brillouin scattering phase conjugate mirror utilizing photonic bandgap guide**

(57)    A phase conjugate mirror (10) comprising a photonic band gap light guide (30) and a stimulated Brillouin scattering medium disposed in operational relation thereto. In specific embodiments, the light guide is an optical fiber (30) with a high index cladding transparent at a propagation wavelength and a hollow or solid core (32'). The cladding (34') is microstructured silica and supports guide modes through frustrated tunneling photonic band gap guidance or Bragg photonic band gap guidance. The fiber has an array of channels (36') disposed around the core. In one embodiment, the fiber is disposed within a stimulated Brillouin scattering cell (20). In this embodiment, the medium is gas, gel, or liquid. In an alternative embodiment, the medium is a solid disposed at the core of the fiber (130). The invention provides a means of guiding light with a gas filled or solid core structure with high guiding efficiency, high reflection back into the medium, without disturbing the polarization state of the light as it propagates.

FIG. 4

Core
PBG Lightguide

Incident Beam ⌐14
Reflected Beam ⌐16

Unconverted portion
of Incident Beam

27  28  10  12  20  30  26  22  18

EP 1 569 031 A1

**Description**

**BACKGROUND OF THE INVENTION**

Field of the Invention:

The present invention relates to optics. More specifically, the present invention relates to optics required for high power solid-state lasers and other applications requiring correction of optical aberration.

Description of the Related Art:

For certain optical applications, high beam quality is required. For example, high power laser amplifiers require high beam quality. Phase conjugate mirrors have been used to correct for distortion in laser beams resulting from imperfect lasing media and optics. Tools are generally used to create a reversed wavefront needed for correction of aberrations in a beam. Often nonlinear optical phase conjugation techniques are used. One alternative technique involves nonlinear stimulated Brillouin scattering (SBS).

Traditional phase conjugate mirrors based on the nonlinear stimulated Brillouin scattering process use bulk focusing within a nonlinear SBS medium to achieve the high electric field strength necessary to generate a Stokes field. A Stokes field is a field of backscattered light that propagates in an opposite direction and at a longer wavelength relative to pump light and interferes therewith.

However, the bulk focus approach limits the performance of the conjugator in two ways. First, the threshold for SBS phase conjugation is related to the field strength as well as the interaction length. By reducing the focal length to increase the field strength, the focal distance is also reduced thereby limiting the interaction length for the nonlinear process. This results in a high peak power threshold for phase conjugation that makes bulk focus SBS impractical for some high average power, high pulse rate applications.

Second, the short interaction length does not allow good diffractive mixing between different parts of the beam which adversely affects phase conjugation fidelity,

It is well known in the art that the performance of SBS phase conjugate mirrors benefit from the long gain-length and the good diffractive mixing that occurs in a guided geometry. Metal guides have been demonstrated with both gaseous and liquid SBS media for this purpose, but are typically very lossy.

Hollow capillary glass light guides have been demonstrated with higher-index liquid SBS media such that the beam propagates down the guide with very low loss via total internal reflection at the liquid-to-glass interface. The numerical aperture of the guide is limited by the difference in refractive indices of the liquid a nd glass. This limiting numerical aperture sets an upper limit on the étendue (area - solid angle product) of the input beam for good phase conjugation. In practice, the allowable étendue may be much lower due to depolarization effects. Also, uncoated glass lightguides cannot be used with low index liquid media or gaseous media, as the index of refraction of the glass is greater than that of the SBS media preventing total internal reflection. Gas media may be preferred for high average power applications, particularly with continuous wave or quasi-continuous wave optical signals, due to boiling of the liquid medium through absorption of the optical radiation.

Conventional glass-core fibers have been used for SBS phase conjugation, but these fibers suffer from the same numerical aperture limits as the liquid guides. Depolarization of the beam within the guide degrades the performance of the PCM. Lengthening a conventional guide in order to enhance the nonlinear interaction or bending it to minimize space tends to exacerbate the depolarization problem. Furthermore, glass-core fibers have low SBS gain, high sound velocities, and long acoustic lifetimes, which limit their tolerance to beam aberrations.

Thus, there is a need in the art for an efficient, robust, low threshold phase conjugate mirror for continuous wave or quasi-continuous wave applications with good polarization maintenance and good conjugation fidelity.

**SUMMARY OF THE INVENTION**

The need in the art is addressed by the phase conjugate mirror of the present invention. In general, the inventive phase conjugate mirror includes a photonic band gap light guide and a stimulated Brillouin scattering medium disposed in operational relation thereto.

In specific embodiments, the light guide is an optical fiber with a cladding transparent at a propagation wavelength and having a hollow or solid core. The cladding is microstructured silica, and it supports guide modes through frustrated tunneling photonic band gap guidance or Bragg photonic band gap guidance. The fiber has an array of holes or channels disposed around the core.

In one embodiment, the fiber is disposed within a stimulated Brillouin scattering cell containing the SBS medium, which could be a gas, gel, or liquid. In an alternative embodiment, the medium is a solid disposed at the core of the fiber, and no cell is required.

Thus, the invention provides a means of guiding light with a fluid-filled or solid core structure with high guiding efficiency, without disturbing the polarization state of the light as it propagates.

**BRIEF DESCRIPTION OF THE DRAWINGS**

Figure 1 is a simplified sectional side view of an SBS phase conjugate mirror using gaseous medium in bulk focus geometry in accordance with conventional teachings.

Figure 2 is a simplified sectional side view of an SBS phase conjugate mirror using liquid medium in lightguide geometry in accordance with conventional teachings.

Figure 3 is an illustrative perspective end view of a photonic band gap (PBG) fiber with hole in center in accordance with conventional teachings.

Figure 4 is a simplified sectional side view of a SBS PCM with gas core PBG light guide in accordance with an illustrative embodiment of the present teachings.

Figure 5 is a simplified sectional side view of a SBS PCM with solid core PBG guide in accordance with an illustrative embodiment of the present teachings.

## DESCRIPTION OF THE INVENTION

Illustrative embodiments and exemplary applications will now be described with reference to the accompanying drawings to disclose the advantageous teachings of the present invention.

While the present invention is described herein with reference to illustrative embodiments for particular applications, it should be understood that the invention is not limited thereto. Those having ordinary skill in the art and access to the teachings provided herein will recognize additional modifications, applications, and embodiments within the scope thereof and additional fields in which the present invention would be of significant utility.

### *SBS Phase Conjugation:*

Stimulated Brillouin Scattering (SBS) is a commonly used nonlinear (electric field strength dependent) process for generating the phase conjugate of a narrowband input optical beam with no external pumps (i.e., self-pumped nonlinear optical phase conjugation). The SBS process is well known in the art and is described in several open literature references, including R. A. Fisher's book entitled Optical Phase Conjugation (Academic Press, New York, 1983). For input optical beams having high peak power (> 100 kW) and moderately good beam quality (< 20 times diffraction limited), SBS can be used with simple bulk focusing to provide high phase conjugate mirror (PCM) reflectivity and good phase conjugation fidelity.

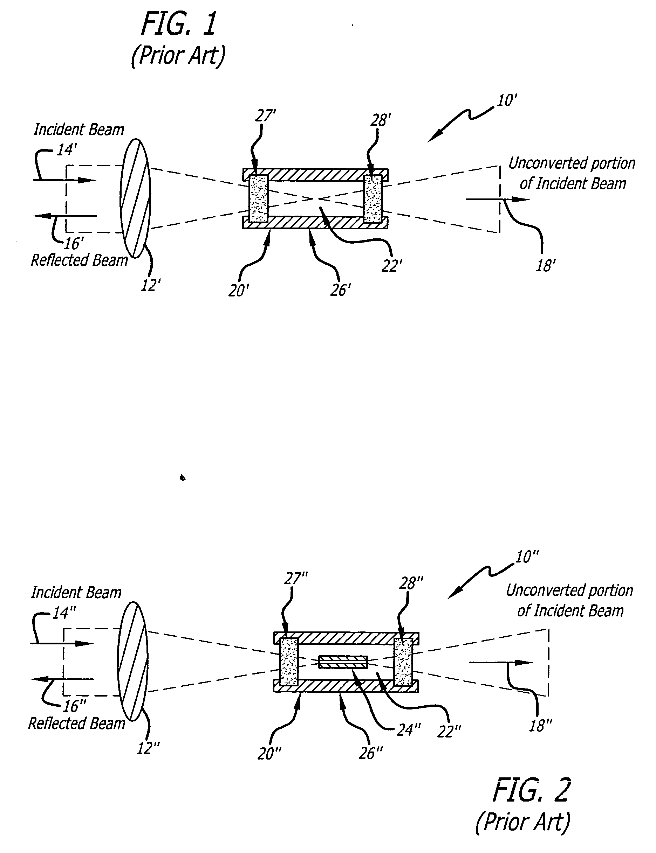

Figure 1 is a simplified schematic sectional side view of an SBS phase conjugate mirror using a gaseous medium with a bulk focus geometry in accordance with conventional teachings. The mirror 10' includes a focusing lens 12' which focuses an incident beam 14' into an SBS cell 20'. The cell 20' has a gas medium 22' which backscatters the incident beam 14' as a reflected beam 16'. The cell 20' further includes cell walls 26' to contain the gas under pressure, an entrance window 27' to allow the incident and reflected beams to be transmitted therethrough, and an exit window 28' to allow the unconverted portion of the incident beam to be transmitted out of the cell.

Phase conjugate mirror (PCM) reflectivity in this context is the ratio of reflected to incident beam powers. The maximum achievable value of PCM reflectivity is nearly 100%, which is determined by the incident beam intensity, focusing geometry, SBS medium nonlinear properties, and gas pressure. PCM reflectivity is ultimately limited by the percentage of incident power that is converted to acoustic power in the medium (Manley-Rowe limit). Phase conjugation fidelity measures the ability of a PCM to return a beam that is an exact conjugate of the input beam. A rigorous definition of phase conjugation fidelity ($\chi$) is given by the following:

$$\chi = \frac{|\int E_{OUT} \cdot E_{IN} \, dx \, dy|^2}{P_{OUT} \cdot P_{IN}}$$

where:

$E_{IN}$ and $E_{OUT}$ are the incident and reflected electric field amplitude profiles
$P_{IN}$ and $P_{OUT}$ are the incident and reflected powers

The fidelity is the fraction of the reflected power contained in an eigenmode that is conjugate to the incident field. The maximum achievable value of phase conjugation fidelity is 100%.

For low peak power or highly aberrated incident beams, the bulk focus geometry may provide low reflectivity and/or poor phase conjugation fidelity. The low reflectivity is believed to result from the fact that the SBS gain is exponentially dependent on the product of the nonlinear gain of the medium, incident intensity, and interaction length in the focal volume. If the focal length of the focusing lens is shortened to decrease the focal spot size in order to increase the incident beam intensity, the focal volume is foreshortened, thereby reducing the interaction length. Increasing the focal length has the converse effect. The result is that the SBS gain for a given medium cannot be arbitrarily improved in a focusing geometry by simple parametric adjustments.

For a Gaussian beam with a 1 μm wavelength, the minimum SBS phase conjugate mirror power threshold in a focused geometry is typically in the range of tens of kilowatts. For highly aberrated beams with complex wavefronts, the SBS PCM threshold increases proportionally to the beam divergence (étendue) and can be too high for laser applications with long pulse or CW optical waveforms.

It has been shown that PCM reflectivity/threshold and phase conjugation fidelity can be improved for low power and/or highly aberrated beams by incorporating the SBS medium in a light guide geometry. See for example:

*1. "A Stimulated Brillouin Scattering Phase-conjugate Mirror Having a Peak-Power Threshold <100 W*," published by D. C. Jones, M. S. Mangir, and D. A. Rockwell, in **Optical Communications** 23, pp. 175-181 (1995) and
*2. "Measurements of SBS Reflectivity and Phase Conjugation Fidelity in Light Guides*," published by M. S. Mangir in **Nonlinear Optics: Materials, Fundamentals, and Applications Conference,** Kauai, Hawaii, July 1998.

One embodiment of the light guide geometry is shown in Figure 2.

Figure 2 is a simplified sectional side view of an SBS phase conjugate mirror 10" using liquid medium in light guide geometry in accordance with conventional teachings. The SBS medium 22" is a liquid, such as carbon disulfide ($CS_2$) or titanium tetrachloride ($TiCl_4$), both of which have a high SBS nonlinear gain and a high refractive index. The light guide is formed by a small internal diameter (< 0.5 mm) glass capillary 24', which is immersed in the liquid SBS medium 22'. The index of refraction of the capillary is less than that of the liquid allowing reflection off the inner walls of the capillary via total internal reflection for shallow grazing angles.

There are several limitations of the liquid light guide SBS PCM described above. First, it is not practical with gas media, as the lower index of refraction of the gas medium will not allow total internal reflection. Metal guides have been used with gas media in an attempt to circumvent this problem, but metal guides are lossy.

Second, the SBS threshold increases with higher angles of incidence entering the guide, thereby causing the SBS reflectivity to fall off with incidence angle. A condition for good phase conjugation fidelity is that all portions of the beam have essentially the same reflectivity. This condition limits the acceptance angle of the guide for phase conjugation to a value well below that determined by geometrical optics (numerical aperture of the guide) restricting the étendue (area - solid angle product) of the incident beam.

Third, phase conjugation is a scalar process, and depolarization of the incident beam within the lightguide represents a loss of phase information and attendant loss of phase conjugation fidelity. Depolarization is caused by phase shifts between the *s* and *p* waves reflected via total internal reflection within the guide. Depolarization increases with the length of the guide and is exacerbated by bending/coiling the guide to make the PCM more compact.

Finally, liquids are difficult to purify, and the residual impurities within the medium may absorb enough of the incident radiation to produce a liquid-to-vapor phase change (i.e., boiling of the liquid). Pressurizing the liquid has been used in liquid lightguide SBS PCMs to increase the threshold for boiling, however this technique is limited by practical constraints on the applied pressure and adds cost and complexity to the PCM apparatus.

*Photonic Bandgap Crystals and Fibers*

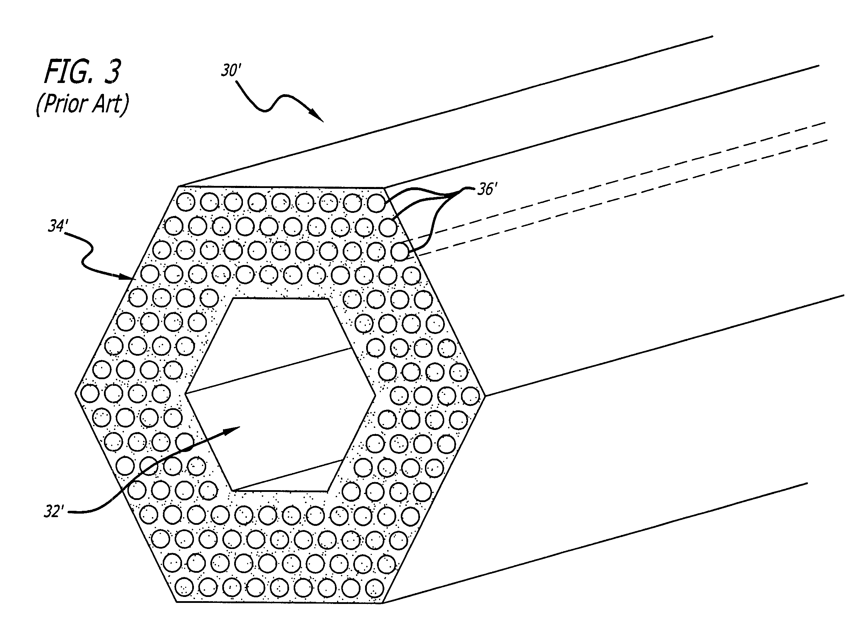

The concept of a Bragg fiber was proposed in the late 1970's by Amnon Yariv and Pochi Yeh. The first microstructured or "holey" fiber was fabricated J.C. Knight, *et al.,* at ORC, Southampton in 1996, and the first microstructured fiber which guided light by a photonic bandgap effect was fabricated by R. F. Cregan, et al, at the University of Bath. The "holey" fiber considered in the present invention is typically a silica fiber with a periodic array of small holes running parallel to the fiber axis. These holes strongly affect the optical properties of the fiber. The center or core of the fiber through which the beam is propagated is either solid silica or has a hole, often larger than the holes in the surrounding periodic array. Figure 3 shows the latter configuration.

Figure 3 is an illustrative perspective end view of a photonic band gap fiber 30' with a hole in center in accordance with conventional teachings. The core 32' is filled with a gaseous medium. The core 32' is surrounded by a periodic array 34' of microstructured silica fibers 36'. These microstructured fibers 36' are disposed in small holes or channels in the periodic array 34' and may be fabricated by stacking and fusing glass tubes together then drawing the preform structure into long fibers using conventional fiber manufacturing processes.

The theory of photonic bandgap guidance in a holey fiber is described by R. F. Cregan, *et al*. in an article entitled *"Single-Mode Photonic Band Gap Guidance of Light in Air,*" published in *Science,* Vol 285, pp. 1537-1539 (Sept. 1999). Two guidance regimes are discussed with respect to PBG structures comprising alternating layers of high and low index as in the holey fiber structure shown in Figure 3: (1) frustrated tunnelling PBG guidance and (2) Bragg PBG guidance. In a frustrated tunneling PBG guidance regime, the light propagates in the layers of high index (surrounding silica material) but is evanescent in the layers of low index (small holes). Light leakage across the holes between the high index regions through resonant tunneling determines which modes are guided (leakage through resonant tunneling within passband) and which are not (resonant tunneling frustrated within band gap).

In the Bragg PBG guidance regime, light can propagate in all layers (not evanescent), however band gaps occur at the Bragg condition, resulting from multiple scattering and interference.

The PBG guidance process does not require a core region with higher index than the cladding, allowing efficient propagation in a gas core fiber. This offers several advantages for high p ower fiber transmission, including high thresholds for breakdown and deleterious nonlinear processes such as stimulated Raman scattering. Low-index liquid cores may also be used, allowing for a larger SBS media selection with liquid lightguide PCM devices. Additionally, the properties of the PBG fiber, such as dispersion, can be readily engineered by tailoring the geometry of the structure (hole spacing and fill factor). Additional advantages include (a) extremely low coupling between propagating modes, even with tight bends in the fiber; (b) single mode operation with large core sizes; and (c) high polarization purity with just slight asymmetry in the structure.

The performance of the PBG fiber is affected by defects in the structure and the finite extent of the periodic array. Defects, for example, introduce localized discontinuities in the bandgap.

The present invention builds on the advances in the field of photonic bandgap fibers. Rather than using the large core diameter afforded by the photonic bandgap structure to suppress nonlinear processes, the present invention encourages the nonlinear stimulated Brillouin scattering process by using a suitably small fiber core diameter and by exploiting the high numerical aperture and polarization preserving properties of the PBG guide to enhance nonlinear optical phase conjugation performance. Although utilizing PBG fibers for the generation of multiple optical wavelengths by nonlinear processes, and more generally in enhanced nonlinear optics, has been suggested in the open literature references [R.F. Cregan paper cited earlier], practical schemes for using PBG structures in guiding SBS PCM devices have not been disclosed.

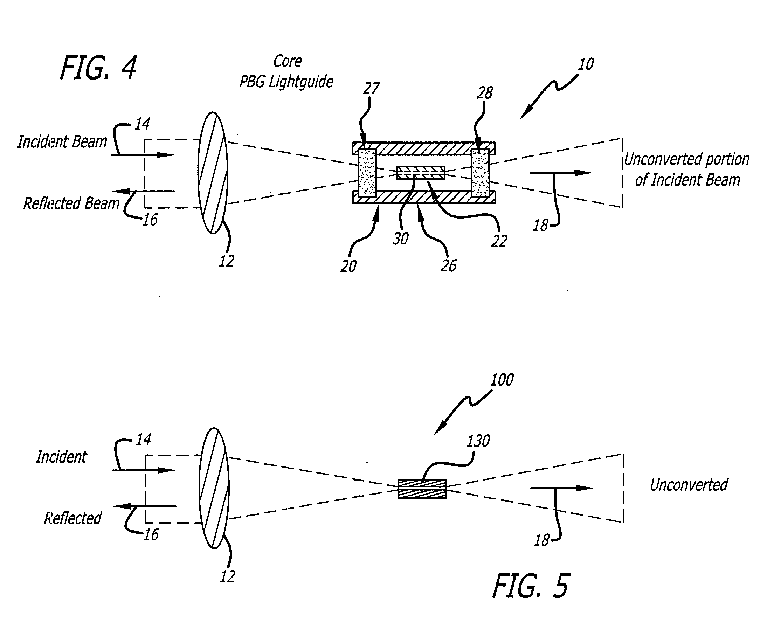

Figure 4 is a simplified sectional side view of an SBS PCM with gas core PBG light guide in accordance with an illustrative embodiment of the present teachings. The mirror 10 of Figure 4 is adapted for use with a focusing lens 12 which focuses an incident beam 14 onto an SBS cell 20. In accordance with the present teachings, the cell 20 includes a gas core photonic band gap (PBG) fiber 30. In the embodiment of Figure 4, the fiber 30 is filled with a gaseous SBS medium, which may include essentially pure $CH_4$, $N_2$, or Xe, mixtures thereof, or other gasses and gas mixtures. In the illustrative embodiment, a high index cladding structure is included and is composed of a homogeneous solid material that is transparent at the propagation wavelength, such as silica. The PBG cladding supports guided modes in the gas core through either frustrated tunneling PBG guidance or Bragg PBG guidance as described above.

The PBG structure may be engineered with a degree of asymmetry through techniques known in the art to enhance the birefringence of the fiber and thus maintain the polarization state of the propagated beam. Such asymmetry may be introduced by fabricating the fiber with an elliptical core. This can be accomplished by stacking capillaries with different wall thickness in the preform, as described by J. Knight, *et al.* in an article entitled *"Photonic Crystal Fibers"* published in **Optics and Photonics News,** pp. 26-30 (March 2002). The PBG structure may be engineered to support a large number of propagation modes with near equal reflectivity, thereby allowing the PCM to operate with highly aberrated beams (high étendue) with good phase conjugation fidelity.

The gas-core fiber structure shown in Figure 4 can also be used with liquid and gel SBS media. Liquid media may include $CS_2$ or $TiCl_4$ or other suitable liquids. The small holes in the PBG structure may require sealing at the ends to preserve index homogeneity within these regions. DC 93500 silicone rubber, obtained from Dow Coming, may be used as the sealing material at the ends of the fiber.

Figure 5 is a simplified sectional side view of a SBS PCM with solid core PBG guide in accordance with an illustrative embodiment of the present teachings. Figure 5 illustrates an alternate embodiment of the present invention wherein the PBG fiber 130 is fabricated with a solid core. In this embodiment, the core may be the same material as the high index cladding.

There are several important applications where this invention is particularly advantageous. The first is in a phase conjugate master oscillator/power amplifier (PC MOPA) laser system such as that described by W. Koechner in *Solid-State Laser Engineering, Second Edition,* Springler-Verlag, Berlin, Germany, pp. 535-539, 1988. For phase conjugate master oscillator power amplifiers (PC MOPAs) that operate in the high average power and high pulse rate regime, the PBG-guided SBS PCM may provide high PCM reflectivity with good phase conjugation fidelity for beams that are highly aberrated by the phase distortions in the power amplifier beamline.

A second application is in an integrated phase conjugate laser and adaptive optics beam control system such as that described by R. Byren and A. Trafton in copending patent application number 09/965,764, entitled SYSTEM AND METHOD FOR EFFECTING HIGH-POWER BEAM CONTROL WITH ADAPTIVE OPTICS IN LOW POWER BEAM PATH, Atty. Docket No. PD-00W089, the teachings of which are hereby incorporated by reference herein.

The third application is in a compensated imaging system such as that described by T. O'Meara in "*Applications of Nonlinear Phase Conjugation in Compensated Active Imaging*" in **Optical Engineering,** *Vol 21,* pp. 231-236 (1982). Other applications for the present invention may be envisioned by those skilled in the art without restricting the scope of the present invention.

It should be appreciated that the drawings and descriptions of the embodiments of the present invention described above are exemplary and that different hole patterns (e.g., rectangular symmetry), cladding thicknesses, focusing apparatus and geometries (multi-lens refractive systems, reflective systems, or diffractive systems), light guide geometry (different core diameter to length aspect ratios, tapered geometries, etc.) may be employed without departing from the scope and spirit of the present invention.

In addition, other nonlinear processes, such as stimulated Raman scattering, that may benefit from the reflectivity, dispersion, and étendue properties of the PBG guide described herein are also included within the scope of this invention.

Thus, the present invention has been described herein with reference to a particular embodiment for a particular application. Those having ordinary skill in the art and access to the present teachings will recognize additional modifications, applications and embodiments within the scope thereof.

It is therefore intended by the appended claims to cover any and all such applications, modifications and embodiments within the scope of the present invention.

Accordingly,

## Claims

1. A phase conjugate mirror (10) comprising:

   a photonic band gap light guide (30) and
   a stimulated Brillouin scattering medium (22) disposed in operational relation to said light guide.

2. The invention of Claim 1 wherein said light guide is an optical fiber.

3. The invention of Claim 2 wherein said fiber has a high index cladding.

4. The invention of Claim 3 wherein said cladding is transparent at a propagation wavelength.

5. The invention of Claim 4 wherein said cladding is a microstructured silica fiber.

6. The invention of Claim 4 wherein said cladding supports guided modes through frustrated tunneling photonic band gap guidance.

7. The invention of Claim 4 wherein said cladding supports guided modes through Bragg photonic band gap guidance.

8. The invention of Claim 2 wherein said fiber has a hollow core.

9. The invention of Claim 8 wherein said fiber has an array of channels disposed around said core.

10. The invention of Claim 1 wherein said fiber is disposed within a stimulated Brillouin scattering cell (20).

11. The invention of Claim 1 wherein said medium is gas.

12. The invention of Claim 1 wherein said medium is a gel.

13. The invention of Claim 1 wherein said medium is a liquid.

14. The invention of Claim 1 wherein said medium is a solid.

15. The invention of Claim 1 further including a focusing lens (12).

# FIG. 1
## (Prior Art)

Incident Beam
14'

16'
Reflected Beam
12'

27'    28'    10'

Unconverted portion
of Incident Beam

20'    26'    22'    18'

# FIG. 2
## (Prior Art)

Incident Beam
14"

16"
Reflected Beam
12"

27"    28"    10"

Unconverted portion
of Incident Beam

20"    26"    24"  22"    18"

FIG. 3
(Prior Art)

FIG. 4

Core
PBG Lightguide

Incident Beam — 14

Reflected Beam — 16

27   28   10

12   20   30   26   22   18

Unconverted portion
of Incident Beam

100

130

Incident — 14

Reflected — 16

12   18

Unconverted

FIG. 5

EP 1 569 031 A1

**European Patent Office**

**EUROPEAN SEARCH REPORT**

Application Number

EP 05 25 0612

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 434 942 A (JACKEL ET AL) 18 July 1995 (1995-07-18) * abstract; figures 1-5 * ----- | 1-13,15 | G02F1/35 |
| Y | CREGAN R F ET AL: "SINGLE-MODE PHOTONIC BAND GAP GUIDANCE OF LIGHT IN AIR" SCIENCE, AMERICAN ASSOCIATION FOR THE ADVANCEMENT OF SCIENCE,, US, vol. 285, no. 5433, 1999, pages 1537-1539, XP000914812 ISSN: 0036-8075 * page 1537 - page 1539; figures 1,2 * ----- | 1-13,15 | |
| Y | JONES D C ET AL: "A stimulated Brillouin scattering phase-conjugate mirror having a peak-power threshold @? 100 W" OPTICS COMMUNICATIONS, NORTH-HOLLAND PUBLISHING CO. AMSTERDAM, NL, vol. 123, no. 1, 15 January 1996 (1996-01-15), pages 175-181, XP004006466 ISSN: 0030-4018 * abstract; figures 1,2,5 * ----- | 1-5,14, 15 | |
| Y | JU HAN LEE ET AL: "INVESTIGATION OF BRILLOUIN EFFECTS IN SMALL-CORE HOLEY OPTICAL FIBER: LASING AND SCATTERING" OPTICS LETTERS, OPTICAL SOCIETY OF AMERICA, WASHINGTON, US, vol. 27, no. 11, 1 June 2002 (2002-06-01), pages 927-929, XP001122426 ISSN: 0146-9592 * page 927 - page 928; figure 1 * ----- -/-- | 1-5,14, 15 | TECHNICAL FIELDS SEARCHED (Int.Cl.7)<br><br>G02F<br>H01S<br>G02B<br>H04B<br>G01F |

The present search report has been drawn up for all claims

| Place of search | Date of completion of the search | Examiner |
|---|---|---|
| Munich | 23 May 2005 | Marani, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 05 25 0612

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EICHLER H J ET AL: "Phase conjugate mirrors" JOURNAL OF NONLINEAR OPTICAL PHYSICS AND MATERIALS WORLD SCIENTIFIC SINGAPORE, vol. 10, no. 1, March 2001 (2001-03), pages 43-52, XP009047903 ISSN: 0218-8635 * the whole document * ----- | 1,2,8, 10,15 | |
| | | | **TECHNICAL FIELDS SEARCHED** (Int.Cl.7) |

The present search report has been drawn up for all claims

| Place of search | Date of completion of the search | Examiner |
|---|---|---|
| Munich | 23 May 2005 | Marani, R |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
............................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 05 25 0612

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2005

| Patent document cited in search report | Publication date | Patent family member(s) | Publication date |
|---|---|---|---|
| US 5434942 A | 18-07-1995 | NONE | |

EPO FORM P0459

For more details about this annex : see Official Journal of the European Patent Office, No. 12/82